# FASCICULE DE BREVET EUROPEEN

(11) **EP 3 671 849 B1**
(45) Date de publication et mention de la délivrance du brevet: **28.04.2021**
(21) Numéro de dépôt: 19215903.6
(22) Date de dépôt: 13.12.2019
(51) Int. Cl.: H01L 27/32, H01L 51/52

(54) **PROCÉDÉ DE FABRICATION D'UN PIXEL D'UN MICRO-ÉCRAN À OLEDS**
ERZEUGUNGSVERFAHREN EINES PIXELS FÜR EINEN MIKRO-OLED-BILDSCHIRM
METHOD FOR MANUFACTURING A PIXEL OF AN OLED MICRO-SCREEN

(30) Priorité: 19.12.2018 FR 1873304
(43) Date de publication de la demande: 24.06.2020
(73) Titulaire: Commissariat à l'énergie atomique et aux énergies alternatives, 75015 Paris (FR)
(72) Inventeur: MOLLARD, Laurent, 38054 GRENOBLE cedex 09 (FR); MAINDRON, Tony, 38054 GRENOBLE cedex 09 (FR); TOURNAIRE, Myriam, 38054 GRENOBLE cedex 09 (FR)
(74) Mandataire: INNOV-GROUP

(56) Documents cités:
- EP-A1- 1 672 962
- US-A1- 2017 243 928

## Description

### Domaine technique

L'invention se rapporte au domaine technique des micro-écrans à diodes électroluminescentes organiques (OLEDs).

L'invention trouve notamment son application dans la fabrication de lunettes et casques à réalité virtuelle ou augmentée, de viseurs d'appareil photo, d'afficheurs tête haute, de pico-projecteurs etc.

### Etat de l'art

Un pixel d'un micro-écran à diodes électroluminescentes organiques à émission vers le haut connu de l'état de la technique, notamment du document EP 1 672 962 A1, comporte successivement :
- un substrat ;
- une première électrode, réfléchissante dans le domaine visible, et formée sur le substrat ;
- une couche d'espacement, formée sur la première électrode ;
- un empilement de couches électroluminescentes organiques, configuré pour émettre une lumière blanche, et formé sur la couche d'espacement,
- une seconde électrode, semi-transparente dans le domaine visible, et formée sur l'empilement ; les première et seconde électrodes formant un résonateur optique.

La couche d'espacement possède des première, deuxième, et troisième portions présentant des épaisseurs adaptées de sorte que le résonateur optique autorise respectivement la transmission de lumières rouge, verte et bleue issues de la lumière blanche émise par l'empilement, de manière à définir respectivement des sous-pixels rouge, vert et bleu.

Un tel pixel de l'état de la technique permet d'envisager de s'affranchir de filtres colorés grâce au résonateur optique de type Fabry-Pérot formant un filtre interférentiel. La gamme de longueurs d'onde filtrées est déterminée par les épaisseurs des première, deuxième et troisième portions de la couche d'espacement permettant d'ajuster l'épaisseur de la cavité optique (délimitée par les première et seconde électrodes) de sorte que le résonateur optique autorise respectivement la transmission de lumières rouge, verte et bleue issue de la lumière blanche émise par l'empilement de couches électroluminescentes organiques.

Ce type de filtrage peut être obtenu de manière analogue pour un micro-écran à émission vers le bas. Pour simplifier la terminologie, on continuera de parler de résonateur, même si les effets d'interférences sont bien moindres en cas d'émission vers le bas.

Toutefois, un tel pixel de l'état de la technique n'est pas entièrement satisfaisant dans la mesure où les première, deuxième et troisième portions de la couche d'espacement sont formées sur la première électrode par des dépôts successifs, ce qui peut occasionner un problème de précision dans le contrôle de leurs épaisseurs.

Par ailleurs, il est connu du document US 2005/0142976 A1 d'utiliser :
- une couche d'ITO polycristallin pour la troisième portion de la couche d'espacement (sous-pixel bleu),
- un empilement de deux couches d'ITO polycristallin pour la deuxième portion de la couche d'espacement (sous-pixel vert),
- un empilement de trois couches d'ITO polycristallin pour la première portion de la couche d'espacement (sous-pixel rouge).

Lors du procédé de fabrication, une première couche d'ITO polycristallin est formée sur la première électrode puis une première couche d'ITO amorphe est déposée (dépôt de type pleine plaque) sur la première couche d'ITO polycristallin. La première couche d'ITO amorphe est ensuite gravée sélectivement -avec un agent de gravure adapté- pour une zone destinée à accueillir un sous-pixel bleu, la première couche d'ITO polycristallin formant une couche d'arrêt. Puis un recuit thermique est appliqué à la première couche d'ITO amorphe afin de former une deuxième couche d'ITO polycristallin.

De façon analogue, une deuxième couche d'ITO amorphe est de nouveau déposée (dépôt de type pleine plaque) puis gravée sélectivement :
- pour la zone destinée à accueillir le sous-pixel bleu, la première couche d'ITO polycristallin formant une couche d'arrêt, et
- pour une zone destinée à accueillir un sous-pixel vert, la deuxième couche d'ITO polycristallin formant une couche d'arrêt.

Enfin, un recuit thermique est appliqué à la deuxième couche d'ITO amorphe afin de former une troisième couche d'ITO polycristallin.

Un tel procédé de la technique permet de bien contrôler l'épaisseur de la couche d'espacement pour les sous-pixels rouge, vert et bleu. Toutefois, un tel procédé de l'état de la technique n'est pas entièrement satisfaisant en termes de temps d'opération et de facilité de mise en œuvre. En effet, les phases de dépôt et de gravure ne peuvent pas être enchaînées rapidement en raison des recuits thermiques qui doivent être appliqués à l'ITO amorphe Le document US2017/0243928 décrit un dispositif organique multicolore comprenant des sous-pixel vert, bleu et rouge. Chaque sous-pixel comprend une électrode composite, une couche organique fonctionnelle et une deuxième électrode. L'épaisseur de l'électrode composite est différente pour chaque sous-pixel de couleur.

### Exposé de l'invention

L'invention vise à remédier en tout ou partie aux inconvénients précités. A cet effet, l'invention a pour objet un procédé de fabrication d'un pixel d'un micro-écran à diodes électroluminescentes organiques, comportant les étapes successives :
a) prévoir un substrat comportant une première électrode structurée ;
b) former successivement des premier et deuxième empilements bicouches sur la première électrode structurée, chaque empilement bicouche comprenant successivement des première et seconde couches réalisées respectivement dans des premier et second matériaux qui sont des oxydes transparents conducteurs pouvant être gravés de manière sélective ;
c) graver le deuxième empilement bicouche pour une zone destinée à accueillir un sous-pixel bleu et pour une zone destinée à accueillir un sous-pixel vert, le deuxième empilement bicouche étant laissé intact sous une zone destinée à accueillir un sous-pixel rouge ;
d) graver le premier empilement bicouche pour la zone destinée à accueillir le sous-pixel bleu, le premier empilement bicouche étant laissé intact sous la zone destinée à accueillir le sous-pixel vert ;
e) former un empilement de couches électroluminescentes organiques, configuré pour émettre une lumière blanche, et s'étendant dans les zones destinées à accueillir les sous-pixels rouge, vert et bleu ;
f) former une seconde électrode sur l'empilement de couches électroluminescentes organiques de manière à obtenir un résonateur optique avec la première électrode ;
   l'étape b) étant exécutée de sorte que :
   - le premier empilement bicouche présente une épaisseur adaptée pour que le résonateur optique autorise la transmission d'une lumière verte,
   - les premier et deuxième empilements bicouches présentent une épaisseur totale adaptée pour que le résonateur optique autorise la transmission d'une lumière rouge.

Ainsi, un tel procédé selon l'invention permet de contrôler les épaisseurs des empilements bicouches de manière satisfaisante grâce à l'étape b) autorisant des dépôts de type pleine plaque et grâce aux étapes c) et d) de gravure. En outre, un tel procédé selon l'invention permet d'enchaîner une phase de dépôts -étape b)- et une phase de gravures -étapes c) et d) - des empilements bicouches, sans nécessiter d'interruptions liées à un recuit thermique comme dans l'état de la technique, ce qui laisse une latitude supplémentaire sur le contrôle des épaisseurs. Un tel procédé selon l'invention permet donc un gain en termes de temps d'opération et de facilité de mise en œuvre.

### Définitions

- Par «micro-écran», on entend un écran dont chaque pixel présente une surface inférieure ou égale à 30 µm par 30 µm.
- Par « substrat », on entend un support physique autoporté, réalisé dans un matériau de base permettant de préférence l'intégration d'un dispositif électronique ou d'un composant électronique. Par exemple, un substrat est classiquement une tranche (« *wafer* » en langue anglaise) découpée dans un lingot monocristallin de matériau semi-conducteur.
- Par « empilement bicouche », on entend soit une unique structure bicouche comportant successivement les première et seconde couches, soit un ensemble de structures bicouches empilées (e.g. de 2 à 4) comportant chacune successivement les première et seconde couches.
- Par « électrode structurée », on entend une électrode présentant une surface discontinue délimitant un ensemble de motifs.
- Par « oxyde transparent conducteur », on entend un oxyde possédant : un coefficient de transmission en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible, une conductivité électrique à 300 K supérieure ou égale à 10² S/cm.
- Par « domaine visible », on entend un spectre électromagnétique compris entre 380 nm et 780 nm.
- Par « gravés de manière sélective », on entend que le second matériau peut être gravé sans attaquer le premier matériau, et réciproquement. En pratique, l'agent de gravure est choisi de sorte que la vitesse de gravure du second matériau (respectivement du premier matériau) est au moins dix fois supérieure à celle du premier matériau (respectivement du second matériau).
- Par « épaisseur », on entend la dimension suivant la normale à la surface du pixel ou du sous-pixel.

Le procédé selon l'invention peut comporter une ou plusieurs des caractéristiques suivantes.

Selon une caractéristique de l'invention, l'étape a) comporte une étape consistant à revêtir la première électrode structurée d'une couche intercalaire réalisée dans le second matériau, la couche intercalaire présentant une épaisseur adaptée pour que le résonateur optique autorise la transmission d'une lumière bleue ;
l'étape b) étant exécutée de sorte que :
- le premier empilement bicouche et la couche intercalaire présentent une épaisseur totale adaptée pour que le résonateur optique autorise la transmission d'une lumière verte,
- les premier et deuxième empilements bicouches et la couche intercalaire présentent une épaisseur totale adaptée pour que le résonateur optique autorise la transmission d'une lumière rouge.

Ainsi, un avantage procuré par une telle couche intercalaire est de pouvoir protéger la première électrode structurée avant l'étape b), avec un rôle d'encapsulation. A cet effet, on choisira préférentiellement un second matériau permettant de protéger la première électrode structurée de l'air et de l'humidité.

Selon une caractéristique de l'invention, le premier matériau est un oxyde de zinc ZnO, de préférence dopé à l'aluminium, et le second matériau est l'oxyde d'étain SnO₂.

Ainsi, de tels premier et second matériaux peuvent être gravés sélectivement en choisissant un agent de gravure adapté, par exemple de l'acide fluorhydrique à 0,1% qui permet de graver sélectivement le ZnO par rapport à SnO₂. En outre, de tels premier et second matériaux possèdent des indices de réfraction très proches, ce qui permet d'éviter des réflexions à l'interface entre les première et seconde couches des empilements bicouches.

Selon une caractéristique de l'invention, l'étape c) comporte les étapes successives :
c₁) graver l'oxyde d'étain SnO₂ du deuxième empilement bicouche par une gravure sèche ou humide,
c₂) graver l'oxyde de zinc ZnO du deuxième empilement bicouche par une gravure humide.

Selon une caractéristique de l'invention, l'étape d) comporte les étapes successives :
d₁) graver l'oxyde d'étain SnO₂ du premier empilement bicouche par une gravure sèche ou humide,
d₂) graver l'oxyde de zinc ZnO du premier empilement bicouche par une gravure humide.

Selon une caractéristique de l'invention, l'étape c) comporte une étape c₀) consistant à masquer la zone destinée à accueillir le sous-pixel rouge par une résine photosensible.

Ainsi, un avantage procuré est de pouvoir laisser intact le deuxième empilement bicouche sous la zone destinée à accueillir le sous-pixel rouge.

Selon une caractéristique de l'invention, l'étape d) comporte une étape d₀) consistant à masquer la zone destinée à accueillir le sous-pixel vert par une résine photosensible.

Ainsi, un avantage procuré est de pouvoir laisser intact le premier empilement bicouche sous la zone destinée à accueillir le sous-pixel vert.

Selon une caractéristique de l'invention, l'étape e) est précédée d'une étape e₀) consistant à graver les premier et deuxième empilements bicouches pour des zones destinées à s'étendre entre les sous-pixels rouge, vert et bleu.

Ainsi, un avantage procuré est de pouvoir isoler électriquement les sous-pixels rouge, vert et bleu entre eux.

Selon une caractéristique de l'invention, l'étape b) est exécutée de sorte que :
- la première couche de chaque empilement bicouche présente une épaisseur comprise entre 10 nm et 100 nm,
- la seconde couche de chaque empilement bicouche présente une épaisseur inférieure ou égale à 10 nm.

Selon une caractéristique de l'invention, les première et seconde électrodes sont réalisées dans un matériau métallique, de préférence sélectionné parmi Al, Ag, Pt, Cr, Ni, W, et/ou réalisées dans un oxyde transparent conducteur.

De tels matériaux métalliques possèdent à la fois un coefficient de réflexion en intensité élevée dans le domaine visible, et une conductivité électrique élevée. On privilégiera un oxyde, électriquement conducteur et transparent dans le domaine visible, lorsque l'électrode doit être transparente ou semi-transparente.

Selon une caractéristique de l'invention, le substrat prévu lors de l'étape a) est transparent dans le domaine visible, la première électrode structurée prévue lors de l'étape a) est semi-transparente dans le domaine visible, la seconde électrode formée lors de l'étape f) est réfléchissante dans le domaine visible.

Par « transparent », on entend que le substrat possède un coefficient de transmission en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.

Par « semi-transparente », on entend que la première électrode structurée possède un coefficient de transmission en intensité compris entre 30% et 70% moyenné sur le domaine visible.

Par « réfléchissante », on entend que la seconde électrode possède un coefficient de réflexion en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.

Ainsi, un avantage procuré est d'obtenir une structure dite à émission vers le bas, c'est-à-dire à travers le substrat.

Selon une caractéristique de l'invention, le substrat prévu lors de l'étape a) est réalisé dans un matériau semi-conducteur, de préférence le silicium, ou réalisé en verre, la première électrode structurée prévue lors de l'étape a) est réfléchissante dans le domaine visible, la seconde électrode formée lors de l'étape f) est semi-transparente dans le domaine visible.

Par « semi-conducteur », on entend que le matériau présente une conductivité électrique à 300 K comprise entre 10⁻⁸ S.cm⁻¹ et 10² S.cm⁻¹.

Par « réfléchissante », on entend que la première électrode structurée possède un coefficient de réflexion en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.

Par « semi-transparente », on entend que la seconde électrode possède un coefficient de transmission en intensité compris entre 30% et 70% moyenné sur le domaine visible.

Ainsi, un avantage procuré est d'obtenir une structure dite à émission vers le haut, c'est-à-dire à travers la seconde électrode. Le substrat peut alors comporter un circuit de commande des sous-pixels rouges, verts, et bleus sans nuire à l'efficacité lumineuse du micro-écran. On choisira un circuit de type TFT (Transistors en couches minces « *Thin Film Transistors* » en langue anglaise) lorsque le substrat est réalisé en verre, et un circuit de type CMOS («*Complementary Metal Oxide Semiconductor* » en langue anglaise) lorsque le substrat est réalisé dans un matériau semi-conducteur, en particulier Si.

### Brève description des dessins

D'autres caractéristiques et avantages apparaîtront dans l'exposé détaillé de différents modes de réalisation de l'invention, l'exposé étant assorti d'exemples et de références aux dessins joints.
Figures 1 à 15 sont des vues schématiques en coupe selon la normale au substrat, illustrant des étapes d'un procédé selon l'invention.
Figure 1 est vue schématique en coupe selon la normale au substrat, illustrant une étape d'un procédé selon l'invention.
Figure 2 est vue schématique en coupe selon la normale au substrat, illustrant une étape d'un procédé selon l'invention.
Figure 3 est vue schématique en coupe selon la normale au substrat, illustrant une étape d'un procédé selon l'invention.
Figure 4 est vue schématique en coupe selon la normale au substrat, illustrant une étape d'un procédé selon l'invention.
Figure 5 est vue schématique en coupe selon la normale au substrat, illustrant une étape d'un procédé selon l'invention.
Figure 6 est vue schématique en coupe selon la normale au substrat, illustrant une étape d'un procédé selon l'invention.
Figure 7 est vue schématique en coupe selon la normale au substrat, illustrant une étape d'un procédé selon l'invention.
Figure 8 est vue schématique en coupe selon la normale au substrat, illustrant une étape d'un procédé selon l'invention.
Figure 9 est vue schématique en coupe selon la normale au substrat, illustrant une étape d'un procédé selon l'invention.
Figure 10 est vue schématique en coupe selon la normale au substrat, illustrant une étape d'un procédé selon l'invention.
Figure 11 est vue schématique en coupe selon la normale au substrat, illustrant une étape d'un procédé selon l'invention.
Figure 12 est vue schématique en coupe selon la normale au substrat, illustrant une étape d'un procédé selon l'invention.
Figure 13 est vue schématique en coupe selon la normale au substrat, illustrant une étape d'un procédé selon l'invention.
Figure 14 est vue schématique en coupe selon la normale au substrat, illustrant une étape d'un procédé selon l'invention.
Figure 15 est vue schématique en coupe selon la normale au substrat, illustrant une étape d'un procédé selon l'invention.
Figure 16 est une vue schématique en coupe selon la normale au substrat, illustrant une étape d'un procédé selon l'invention.
Figure 17 est une vue schématique en coupe selon la normale au substrat, illustrant une étape d'un procédé selon l'invention.

Il est à noter que les dessins décrits ci-avant sont schématiques et ne sont pas à l'échelle par souci de lisibilité et pour simplifier leur compréhension.

### Exposé détaillé des modes de réalisation

Les éléments identiques ou assurant la même fonction porteront les mêmes références pour les différents modes de réalisation, par souci de simplification.

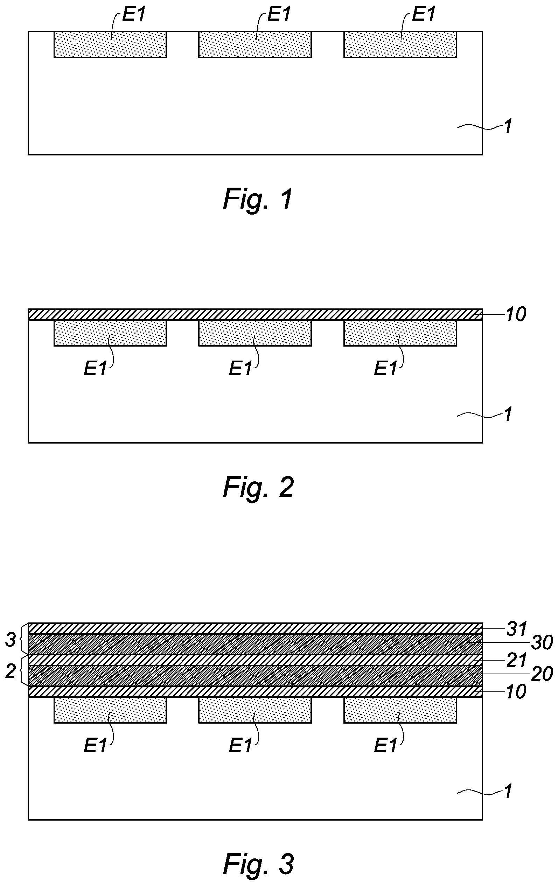

Comme illustré aux figures 1 à 15, un objet de l'invention est un procédé de fabrication d'un pixel d'un micro-écran à diodes électroluminescentes organiques, comportant les étapes successives :
a) prévoir un substrat 1 comportant une première électrode E1 structurée ;
b) former successivement des premier et deuxième empilements bicouches 2, 3 sur la première électrode structurée, chaque empilement bicouche 2, 3 comprenant successivement des première et seconde couches 20, 21 ; 30, 31 réalisées respectivement dans des premier et second matériaux qui sont des oxydes transparents conducteurs pouvant être gravés de manière sélective ;
c) graver le deuxième empilement bicouche 3 pour une zone destinée à accueillir un sous-pixel bleu PB et pour une zone destinée à accueillir un sous-pixel vert PV, le deuxième empilement bicouche 3 étant laissé intact sous une zone destinée à accueillir un sous-pixel rouge PR ;
d) graver le premier empilement bicouche 2 pour la zone destinée à accueillir le sous-pixel bleu PB, le premier empilement bicouche 2 étant laissé intact sous la zone destinée à accueillir le sous-pixel vert PV ;
e) former un empilement 5 de couches électroluminescentes organiques, configuré pour émettre une lumière blanche, et s'étendant dans les zones destinées à accueillir les sous-pixels rouge, vert et bleu PR, PV, PB ;
f) former une seconde électrode E2 sur l'empilement 5 de couches électroluminescentes organiques de manière à obtenir un résonateur optique avec la première électrode E1 ;
   l'étape b) étant exécutée de sorte que :
   - le premier empilement bicouche 2 présente une épaisseur adaptée pour que le résonateur optique autorise la transmission d'une lumière verte,
   - les premier et deuxième empilements bicouches 2, 3 présentent une épaisseur totale adaptée pour que le résonateur optique autorise la transmission d'une lumière rouge.

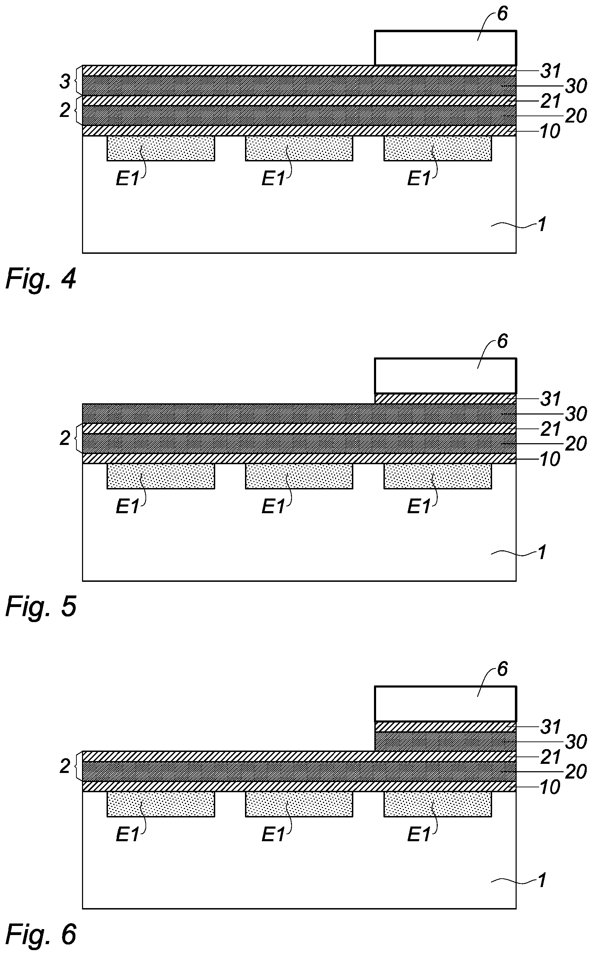

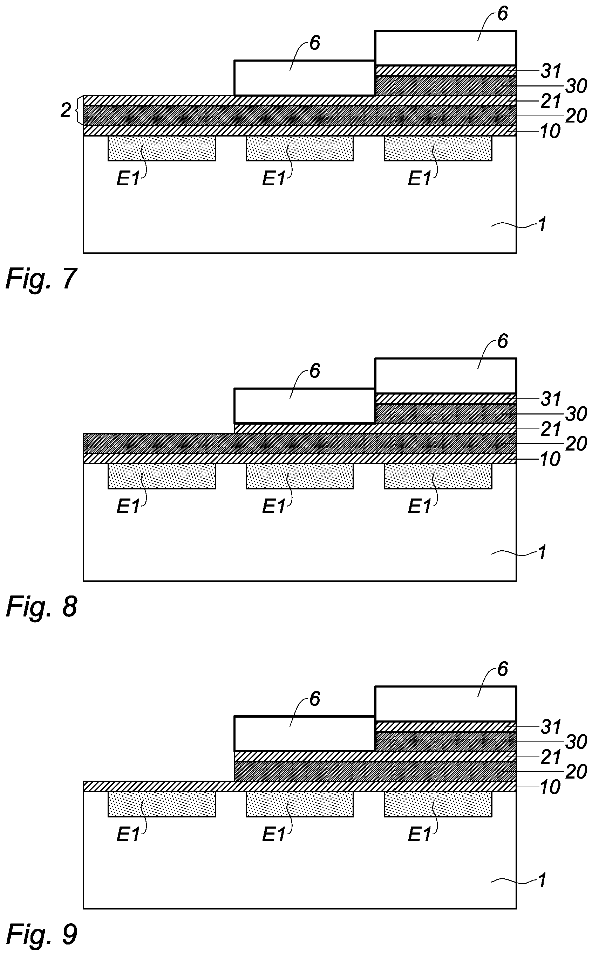

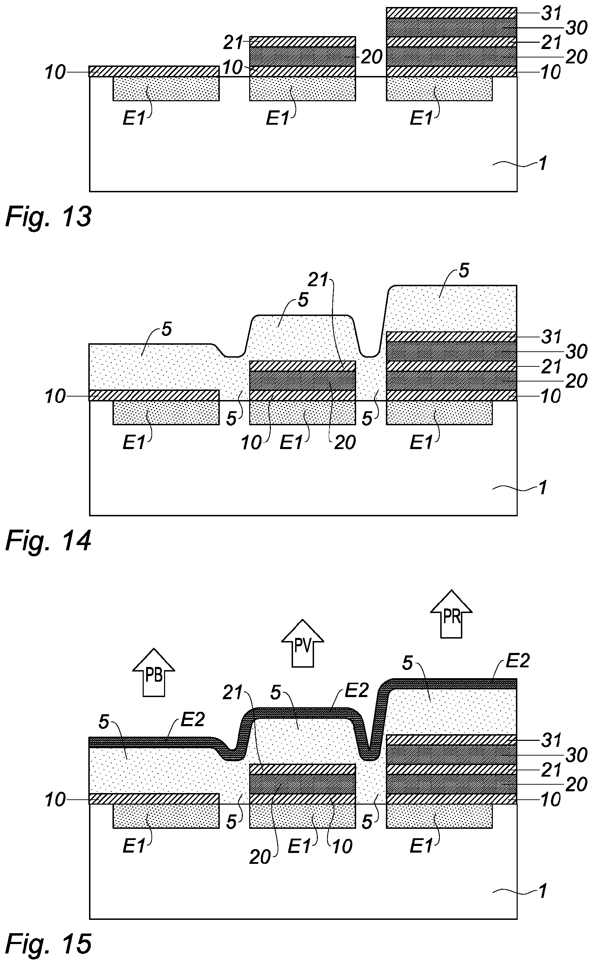

L'étape a) est illustrée à la figure 1. L'étape b) est illustrée à la figure 3. L'étape c) est illustrée aux figures 4 à 6. L'étape d) est illustrée aux figures 7 à 9. L'étape e) est illustrée à la figure 14. L'étape f) est illustrée à la figure 15.

### Substrat et types d'architectures

Selon une première architecture dite à émission vers le bas :
- le substrat 1 prévu lors de l'étape a) est transparent dans le domaine visible, et peut être réalisé en verre,
- la première électrode E1 structurée prévue lors de l'étape a) est semi-transparente dans le domaine visible, et peut être réalisée par exemple dans un oxyde transparent conducteur,
- la seconde électrode E2 formée lors de l'étape f) est réfléchissante dans le domaine visible, et peut être réalisée par exemple dans un matériau métallique.

Selon une seconde architecture dite à émission vers le haut :
- le substrat 1 prévu lors de l'étape a) est réalisé dans un matériau semi-conducteur, de préférence le silicium, ou réalisé en verre,
- la première électrode E1 structurée prévue lors de l'étape a) est réfléchissante dans le domaine visible, et peut être par exemple réalisée dans un matériau métallique,
- la seconde électrode E2 formée lors de l'étape f) est semi-transparente dans le domaine visible, et peut être par exemple réalisée dans un oxyde transparent conducteur.

### Première électrode structurée

La première électrode E1 structurée est avantageusement réalisée dans un matériau métallique, de préférence sélectionné parmi Al, Ag, Pt, Cr, Ni, W, Mo, Ti, Ru, Pd, ou réalisée dans un oxyde transparent conducteur. Le matériau métallique peut être dopé, par exemple avec du cuivre pour l'aluminium. La première électrode structurée E1 peut présenter une épaisseur comprise entre 100 nm et 300 nm. La première électrode structurée E1 peut être recouverte d'une couche de passivation. A titre d'exemples non limitatifs, la couche de passivation peut être réalisée en TiN, et présente préférentiellement une épaisseur inférieure à 10 nm.

La première électrode E1 structurée est préférentiellement une anode. Toutefois, la première électrode E1 peut être une cathode si la structure de l'empilement 5 de couches électroluminescentes organiques est inversée.

L'étape a) peut comporter les étapes :
a₁) prévoir le substrat 1 ;
a₂) déposer la première électrode E1 sur le substrat 1 par un dépôt de type pleine plaque, selon une technique de dépôt connue de l'homme du métier ;
a₃) structurer la première électrode E1 par une lithogravure.

Les motifs de la première électrode E1 structurée sont préférentiellement séparés d'une largeur comprise entre 0,6 µm et 1 µm. Cette largeur permet d'obtenir un pas d'une matrice de sous-pixels d'un micro-écran préférentiellement compris entre 4 µm et 5 µm.

Lorsque l'architecture est à émission vers le bas, la première électrode E1 structurée présente une épaisseur adaptée pour être semi-transparente dans le domaine visible. La première électrode E1 peut alors être réalisée par exemple dans un oxyde transparent conducteur (e.g. ITO). Lorsque l'architecture est à émission vers le haut, la première électrode E1 structurée présente une épaisseur adaptée pour être réfléchissante dans le domaine visible. La première électrode E1 peut alors être par exemple réalisée dans un matériau métallique.

### Formation des empilements bicouches

Le premier matériau est avantageusement un oxyde de zinc ZnO, de préférence dopé à l'aluminium. Le second matériau est avantageusement l'oxyde d'étain SnO₂. On choisira avantageusement des premier et second matériaux possédant des indices de réfraction suffisamment proches afin d'éviter des réflexions à l'interface entre les première et seconde couches 20, 21 ; 30, 31 des empilements bicouches 2, 3. A titre d'exemple, les premier et second matériaux possèdent avantageusement des indices de réfraction avec un écart inférieur ou égal à 25%, de préférence inférieur ou égal à 20%.

L'étape b) est exécutée par des techniques de dépôt connues de l'homme du métier, par exemple par ALD (« *Atomic Loyer Deposition* » en langue anglaise »).

L'étape b) est avantageusement exécutée de sorte que :
- la première couche 20, 30 de chaque empilement bicouche 2, 3 présente une épaisseur comprise entre 10 nm et 100 nm,
- la seconde couche 21, 31 de chaque empilement bicouche 2, 3 présente une épaisseur inférieure ou égale à 10 nm.

### Gravure des empilements bicouches

L'étape c) comporte avantageusement les étapes successives :
c₁) graver l'oxyde d'étain SnO₂ du deuxième empilement bicouche 3 par une gravure sèche ou humide,
c₂) graver l'oxyde de zinc ZnO du deuxième empilement bicouche 3 par une gravure humide.

L'étape c₁) est illustrée à la figure 5. L'étape c₂) est illustrée à la figure 6.

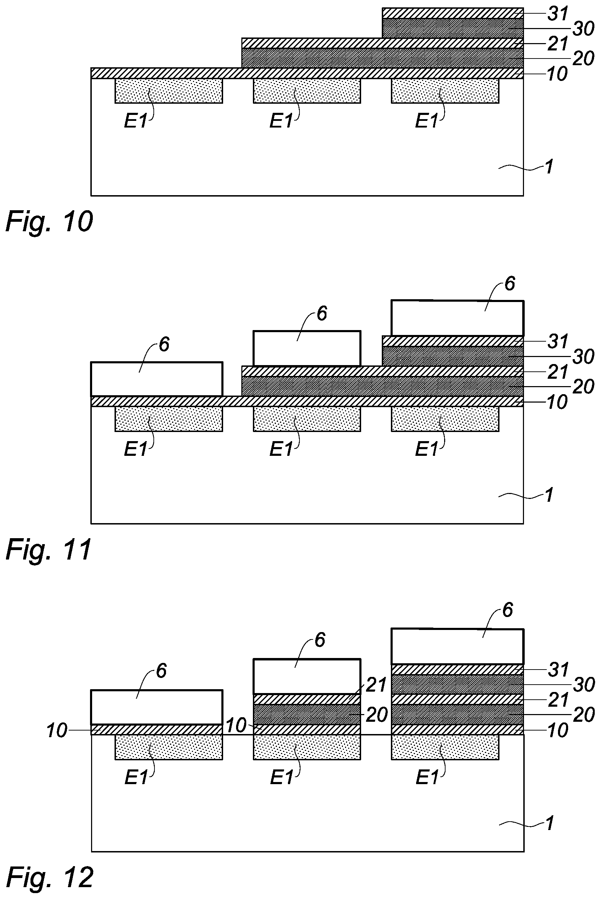

L'étape c) comporte avantageusement une étape c₀) consistant à masquer la zone destinée à accueillir le sous-pixel rouge PR par une résine 6 photosensible. L'étape c₀) est illustrée à la figure 4. Comme illustré à la figure 10, la résine 6 photosensible est supprimée avant l'étape e) par une technique de retrait (« *stripping* » en langue anglaise ») connue de l'homme du métier.

L'étape c₁) est exécutée avec un agent de gravure permettant de graver sélectivement l'oxyde d'étain SnO₂ par rapport à l'oxyde de zinc ZnO. Lors de l'étape c₁), la première couche 30 du deuxième empilement bicouche 3 agit comme une couche d'arrêt pour la gravure de la seconde couche 31 du deuxième empilement bicouche 3. De manière alternative, il est possible de prévoir une épaisseur suffisamment importante de ZnO (i.e. la première couche 30 du deuxième empilement bicouche 3) afin de compenser une éventuelle surgravure du SnO₂ (i.e. la seconde couche 31 du deuxième empilement bicouche 3).

L'étape c₂) est exécutée avec un agent de gravure permettant de graver sélectivement l'oxyde de zinc ZnO par rapport à l'oxyde d'étain SnO₂, par exemple avec de l'acide fluorhydrique (HF) à 0,1%. Lors de l'étape c₂), la seconde couche 21 du premier empilement bicouche 2 agit comme une couche d'arrêt pour la gravure de la première couche 30 du deuxième empilement bicouche 3.

L'étape d) comporte avantageusement les étapes successives :
d₁) graver l'oxyde d'étain SnO₂ du premier empilement bicouche 2 par une gravure sèche ou humide,
d₂) graver l'oxyde de zinc ZnO du premier empilement bicouche 2 par une gravure humide.

L'étape d₁) est illustrée à la figure 8. L'étape c₂) est illustrée à la figure 9.

L'étape d) comporte avantageusement une étape d₀) consistant à masquer la zone destinée à accueillir le sous-pixel vert PV par une résine 6 photosensible. L'étape d₀) est illustrée à la figure 7. Comme illustré à la figure 10, la résine 6 photosensible est supprimée avant l'étape e) par une technique de retrait (« *stripping* » en langue anglaise ») connue de l'homme du métier.

L'étape d₁) est exécutée avec un agent de gravure permettant de graver sélectivement l'oxyde d'étain SnO₂ par rapport à l'oxyde de zinc ZnO. Lors de l'étape d_{1*}), la première couche 20 du premier empilement bicouche 2 agit comme une couche d'arrêt pour la gravure de la seconde couche 21 du premier empilement bicouche 2.

L'étape d₂) est exécutée avec un agent de gravure permettant de graver sélectivement l'oxyde de zinc ZnO par rapport à l'oxyde d'étain SnO₂. Lors de l'étape d₂), la couche intercalaire 10 agit comme une couche d'arrêt pour la gravure de la première couche 20 du premier empilement bicouche 2.

### Couche intercalaire

Comme illustré à la figure 2, l'étape a) comporte avantageusement une étape a₄) consistant à revêtir la première électrode E1 structurée d'une couche intercalaire 10 réalisée dans le second matériau. L'étape a₄) est réalisée par une technique de dépôt connue de l'homme du métier, par exemple par ALD (« *Atomic Layer Déposition* » en langue anglaise »). La couche intercalaire 10 est ainsi intercalée entre la première électrode E1 structurée et le premier empilement bicouche 2. La couche intercalaire 10 présente une épaisseur adaptée pour que le résonateur optique autorise la transmission d'une lumière bleue.

L'étape b) est alors exécutée de sorte que :
- le premier empilement bicouches 2 et la couche intercalaire 10 présentent une épaisseur totale adaptée pour que le résonateur optique autorise la transmission d'une lumière verte,
- les premier et deuxième empilements bicouches 2, 3 et la couche intercalaire 10 présentent une épaisseur totale adaptée pour que le résonateur optique autorise la transmission d'une lumière rouge.

Une telle couche intercalaire 10, réalisée en oxyde d'étain SnO₂, permet de protéger la première électrode E1 structurée de l'air et de l'humidité. En outre, une telle couche intercalaire 10 contribue à former partiellement la couche d'espacement du résonateur optique.

### Isolation électrique des sous-pixels

Comme illustré aux figures 11 et 12, l'étape e) est avantageusement précédée d'une étape e₀) consistant à graver les premier et deuxième empilements bicouches 2, 3 pour des zones destinées à s'étendre entre les sous-pixels rouge, vert et bleu PR, PV, PB. L'étape e₀) est de préférence exécutée par une gravure sèche. L'étape e₀) est illustrée à la figure 12.

On choisira de préférence un agent de gravure permettant de graver simultanément (et non de manière sélective) les premier et deuxième empilements bicouches 2, 3 pour les zones destinées à s'étendre entre les sous-pixels rouge, vert et bleu PR, PV, PB, et ce afin de diminuer la durée d'opération du procédé. A titre d'exemple non limitatif, l'agent de gravure peut être l'acide iodhydrique. Selon une alternative, l'étape e₀) peut être une gravure ionique réactive (RIE), de préférence chlorée (e.g. Cl₂/Ar).

Comme illustré à la figure 11, l'étape e₀) comporte préalablement une étape consistant à masquer les zones destinées à s'étendre entre les sous-pixels rouge, vert et bleu PR, PV, PB par une résine 6 photosensible. Comme illustré à la figure 13, la résine 6 photosensible est supprimée avant l'étape e) par une technique de retrait (« *stripping* » en langue anglaise ») connue de l'homme du métier.

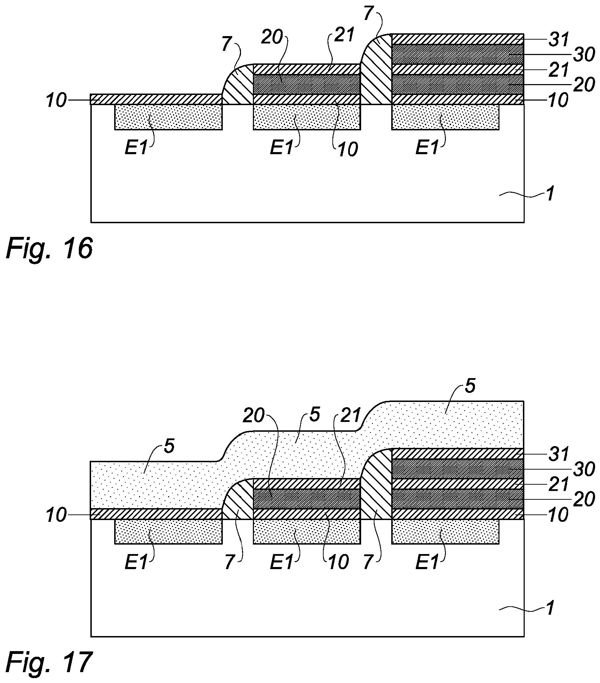

L'étape e₀) peut être suivie d'une étape (illustrée aux figures 16 et 17) consistant à remplir les zones destinées à s'étendre entre les sous-pixels rouge, vert et bleu PR, PV, PB d'un matériau diélectrique 7, par exemple sous la forme d'une résine. A titre d'exemple non limitatif, le matériau diélectrique 7 peut être une résine isolante déposée par tournette, et soumise à une photolithographie pour ne laisser subsister que des plots de résine entre deux sous-pixels adjacents. Il en résulte une bonne isolation électrique entre les sous-pixels rouge, vert et bleu PR, PV, PB.

### Empilement de couches électroluminescentes organiques

L'empilement 5 de couches électroluminescentes organiques formé lors de l'étape e) présente une épaisseur constante pour chaque sous-pixel rouge, vert et bleu PR, PV, PB.

A titre d'exemple non limitatif, l'empilement 5 de couches électroluminescentes organiques peut comporter trois couches émissives en architecture tandem. Plus précisément, lorsque la première électrode E1 structurée est une anode et la seconde électrode E2 est une cathode, l'empilement 4 peut comporter :
- une première couche de transport de trous formée sur la première électrode E1 structurée ;
- une première couche émissive émettant une lumière bleue, formée sur la première couche de transport de trous ;
- une première couche de transport d'électrons, formée sur la première couche émissive ;
- une couche de génération de charges (appelée également couche d'interconnexion), formée sur la première couche de transport d'électrons ;
- une seconde couche de transport de trous, formée sur la couche de génération de charges ;
- une deuxième couche émissive émettant une lumière verte, formée sur la seconde couche de transport de trous ;
- une troisième couche émissive émettant une lumière rouge, formée sur la deuxième couche émissive ;
- une seconde couche de transport d'électrons, formée sur la troisième couche émissive, et destinée à être revêtue de la seconde électrode E2.

A titre de variantes, l'empilement 5 de couches électroluminescentes organiques peut comporter :
- trois couches émissives émettant respectivement des lumières bleue, verte et rouge sans être agencées en architecture tandem (structure conventionnelle) ;
- deux couches émissives émettant respectivement des lumières jaune et bleue agencées en structure conventionnelle ;
- deux couches émissives émettant respectivement des lumières jaune et bleue agencées en structure tandem.

L'étape e) est exécutée par des techniques de dépôt connues de l'homme du métier.

### Seconde électrode

La seconde électrode E2 est avantageusement réalisée dans un matériau métallique, de préférence sélectionné parmi Al, Ag, Pt, Cr, Ni, W, ou réalisée dans un oxyde transparent conducteur.

La seconde électrode E2 est préférentiellement une cathode. Toutefois, la seconde électrode E2 peut être une anode si la structure de l'empilement 5 de couches électroluminescentes organiques est inversée.

L'étape f) est exécutée par une technique de dépôt connue de l'homme du métier.

La seconde électrode E2 est avantageusement revêtue d'une couche d'encapsulation (non illustrée) adaptée pour protéger de l'air et de l'humidité la seconde électrode E2 et l'empilement 5 de couches électroluminescentes organiques.

Lorsque l'architecture est à émission vers le bas, la seconde électrode E2 présente une épaisseur adaptée pour être réfléchissante dans le domaine visible. La seconde électrode E2 peut alors être par exemple réalisée dans un matériau métallique. Lorsque l'architecture est à émission vers le haut, la seconde électrode E2 présente une épaisseur adaptée pour être semi-transparente dans le domaine visible. La seconde électrode E2 peut alors être réalisée par exemple dans un oxyde transparent conducteur (e.g. ITO).

L'invention ne se limite pas aux modes de réalisation exposés. L'homme du métier est mis à même de considérer leurs combinaisons techniquement opérantes, et de leur substituer des équivalents en restant dans le cadre de l'étendue de l'invention telle que définie dans les revendications annexées.

## Revendications

1. Procédé de fabrication d'un pixel d'un micro-écran à diodes électroluminescentes organiques, comportant les étapes successives :
a) prévoir un substrat (1) comportant une première électrode (E1) structurée ;
b) former successivement des premier et deuxième empilements bicouches (2, 3) sur la première électrode (E1) structurée, chaque empilement bicouche (2, 3) comprenant successivement des première et seconde couches (20, 21 ; 30, 31) réalisées respectivement dans des premier et second matériaux qui sont des oxydes transparents conducteurs pouvant être gravés de manière sélective ;
c) graver le deuxième empilement bicouche (3) pour une zone destinée à accueillir un sous-pixel bleu (PB) et pour une zone destinée à accueillir un sous-pixel vert (PV), le deuxième empilement bicouche (3) étant laissé intact sous une zone destinée à accueillir un sous-pixel rouge (PR) ;
d) graver le premier empilement bicouche (2) pour la zone destinée à accueillir le sous-pixel bleu (PB), le premier empilement bicouche (2) étant laissé intact sous la zone destinée à accueillir le sous-pixel vert (PV) ;
e) former un empilement (5) de couches électroluminescentes organiques, configuré pour émettre une lumière blanche, et s'étendant dans les zones destinées à accueillir les sous-pixels rouge, vert et bleu (PR, PV, PB) ;
f) former une seconde électrode (E2) sur l'empilement (5) de couches électroluminescentes organiques de manière à obtenir un résonateur optique avec la première électrode (E1) ;
l'étape b) étant exécutée de sorte que :
- le premier empilement bicouche (2) présente une épaisseur adaptée pour que le résonateur optique autorise la transmission d'une lumière verte,
- les premier et deuxième empilements bicouches (2, 3) présentent une épaisseur totale adaptée pour que le résonateur optique autorise la transmission d'une lumière rouge.

2. Procédé selon la revendication 1, dans lequel l'étape a) comporte une étape consistant à revêtir la première électrode (E1) structurée d'une couche intercalaire (10) réalisée dans le second matériau, la couche intercalaire (10) présentant une épaisseur adaptée pour que le résonateur optique autorise la transmission d'une lumière bleue ;
l'étape b) étant exécutée de sorte que :
- le premier empilement bicouche (2) et la couche intercalaire (10) présentent une épaisseur totale adaptée pour que le résonateur optique autorise la transmission d'une lumière verte,
- les premier et deuxième empilements bicouches (2, 3) et la couche intercalaire (10) présentent une épaisseur totale adaptée pour que le résonateur optique autorise la transmission d'une lumière rouge.

3. Procédé selon la revendication 1 ou 2, dans lequel le premier matériau est un oxyde de zinc ZnO, de préférence dopé à l'aluminium, et le second matériau est l'oxyde d'étain SnO₂.

4. Procédé selon la revendication 3, dans lequel l'étape c) comporte les étapes successives :
c₁) graver l'oxyde d'étain SnO₂ du deuxième empilement bicouche (3) par une gravure sèche ou humide,
c₂) graver l'oxyde de zinc ZnO du deuxième empilement bicouche (3) par une gravure humide.

5. Procédé selon la revendication 3 ou 4, dans lequel l'étape d) comporte les étapes successives :
d₁) graver l'oxyde d'étain SnO₂ du premier empilement bicouche (2) par une gravure sèche ou humide,
d₂) graver l'oxyde de zinc ZnO du premier empilement bicouche (2) par une gravure humide.

6. Procédé selon l'une des revendications 1 à 5, dans lequel l'étape c) comporte une étape c₀) consistant à masquer la zone destinée à accueillir le sous-pixel rouge (PR) par une résine (6) photosensible.

7. Procédé selon l'une des revendications 1 à 6, dans lequel l'étape d) comporte une étape d₀) consistant à masquer la zone destinée à accueillir le sous-pixel vert (PV) par une résine (6) photosensible.

8. Procédé selon l'une des revendications 1 à 7, dans lequel l'étape e) est précédée d'une étape e₀) consistant à graver les premier et deuxième empilements bicouches (2, 3) pour des zones destinées à s'étendre entre les sous-pixels rouge, vert et bleu (PR, PV, PB).

9. Procédé selon l'une des revendications 1 à 8, dans lequel l'étape b) est exécutée de sorte que :
- la première couche (20, 30) de chaque empilement bicouche (2, 3) présente une épaisseur comprise entre 10 nm et 100 nm,
- la seconde couche (21, 31) de chaque empilement bicouche (2, 3) présente une épaisseur inférieure ou égale à 10 nm.

10. Procédé selon l'une des revendications 1 à 9, dans lequel les première et seconde électrodes (E1, E2) sont réalisées dans un matériau métallique, de préférence sélectionné parmi Al, Ag, Pt, Cr, Ni, W, et/ou réalisées dans un oxyde transparent conducteur.

11. Procédé selon l'une des revendications 1 à 10, dans lequel :
- le substrat (1) prévu lors de l'étape a) est transparent dans le domaine visible,
- la première électrode (E1) structurée prévue lors de l'étape a) est semi-transparente dans le domaine visible,
- la seconde électrode (E2) formée lors de l'étape f) est réfléchissante dans le domaine visible.

12. Procédé selon l'une des revendications 1 à 10, dans lequel :
- le substrat (1) prévu lors de l'étape a) est réalisé dans un matériau semi-conducteur, de préférence le silicium, ou réalisé en verre,
- la première électrode (E1) structurée prévue lors de l'étape a) est réfléchissante dans le domaine visible,
- la seconde électrode (E2) formée lors de l'étape f) est semi-transparente dans le domaine visible.

## Patentansprüche

1. Verfahren zur Herstellung eines Pixels eines Mikrobildschirms mit organischen Leuchtdioden, aufweisend die folgenden aufeinanderfolgenden Schritte:
a) Vorsehen eines Substrats (1), das eine erste strukturierte Elektrode (E1) aufweist;
b) Bilden eines ersten und zweiten Doppelschichtstapels (2, 3) nacheinander auf der ersten strukturierten Elektrode (E1), wobei jeder Doppelschichtstapel (2, 3) nacheinander eine erste und zweite Schicht (20, 21; 30, 31) umfasst, die jeweils aus einem ersten und zweiten Material hergestellt sind, die leitende transparente Oxide sind, die selektiv geätzt werden können;
c) Ätzen des zweiten Doppelschichtstapels (3) für einen Bereich zur Aufnahme eines blauen Subpixels (PB) und für einen Bereich zur Aufnahme eines grünen Subpixels (PV), wobei der zweite Doppelschichtstapel (3) unter einem Bereich zur Aufnahme eines roten Subpixels (PR) intakt gelassen wird;
d) Ätzen des ersten Doppelschichtstapels (2) für den Bereich zur Aufnahme des blauen Subpixels (PB), wobei der erste Doppelschichtstapel (2) unter dem Bereich zur Aufnahme des grünen Subpixels (PV) intakt gelassen wird;
e) Bilden eines Stapels (5) aus organischen elektrolumineszenten Schichten, der dazu ausgebildet ist, ein weißes Licht abzugeben, und sich in den Bereichen erstreckt, die dazu bestimmt sind, den roten, grünen und blauen Subpixel (PR, PV, PB) aufzunehmen;
f) Bilden einer zweiten Elektrode (E2) auf dem Stapel (5) aus organischen elektrolumineszenten Schichten, um einen optischen Resonator mit der ersten Elektrode (E1) zu erhalten;
wobei der Schritt b) so ausgeführt wird, dass:
- der erste Doppelschichtstapel (2) eine geeignete Dicke aufweist, damit der optische Resonator die Übertragung eines grünen Lichts gestattet,
- der erste und zweite Doppelschichtstapel (2, 3) eine geeignete Gesamtdicke aufweisen, damit der optische Resonator die Übertragung eines roten Lichts gestattet.

2. Verfahren nach Anspruch 1, wobei der Schritt a) einen Schritt aufweist, der darin besteht, die erste strukturierte Elektrode (E1) mit einer Zwischenschicht (10) zu beschichten, die aus dem zweiten Material hergestellt ist, wobei die Zwischenschicht (10) eine geeignete Dicke aufweist, damit der optische Resonator die Übertragung eines blauen Lichts gestattet;
wobei der Schritt b) so ausgeführt wird, dass:
- der erste Doppelschichtstapel (2) und die Zwischenschicht (10) eine geeignete Gesamtdicke aufweisen, damit der optische Resonator die Übertragung eines grünen Lichts gestattet,
- der erste und zweite Doppelschichtstapel (2, 3) und die Zwischenschicht (10) eine geeignete Gesamtdicke aufweisen, damit der optische Resonator die Übertragung eines roten Lichts gestattet.

3. Verfahren nach Anspruch 1 oder 2, wobei das erste Material ein Zinkoxid ZnO ist, das vorzugsweise aluminiumdotiert ist, und das zweite Material das Zinnoxid SnO₂ ist.

4. Verfahren nach Anspruch 3, wobei der Schritt c) die folgenden aufeinanderfolgenden Schritte aufweist:
c₁) Ätzen des Zinnoxids SnO₂ des zweiten Doppelschichtstapels (3) durch eine Trocken- oder Nassätzung,
c₂) Ätzen des Zinkoxids ZnO des zweiten Doppelschichtstapels (3) durch eine Nassätzung.

5. Verfahren nach Anspruch 3 oder 4, wobei der Schritt d) die folgenden aufeinanderfolgenden Schritte aufweist:
d₁) Ätzen des Zinnoxids SnO₂ des ersten Doppelschichtstapels (2) durch eine Trocken- oder Nassätzung,
d₂) Ätzen des Zinkoxids ZnO des ersten Doppelschichtstapels (2) durch eine Nassätzung.

6. Verfahren nach einem der Ansprüche 1 bis 5, wobei der Schritt c) einen Schritt c₀) aufweist, der darin besteht, den Bereich zur Aufnahme des roten Subpixels (PR) mit einem lichtempfindlichen Harz (6) zu maskieren.

7. Verfahren nach einem der Ansprüche 1 bis 6, wobei der Schritt d) einen Schritt d₀) aufweist, der darin besteht, den Bereich zur Aufnahme des grünen Subpixels (PV) mit einem lichtempfindlichen Harz (6) zu maskieren.

8. Verfahren nach einem der Ansprüche 1 bis 7, wobei dem Schritt e) ein Schritt e₀) vorangeht, der darin besteht, den ersten und zweiten Doppelschichtstapel (2, 3) für Bereiche zu ätzen, die dazu bestimmt sind, sich zwischen dem roten, grünen und blauen Subpixel (PR, PV, PB) zu erstrecken.

9. Verfahren nach einem der Ansprüche 1 bis 8, wobei der Schritt b) so ausgeführt wird, dass:
- die erste Schicht (20, 30) jedes Doppelschichtstapels (2, 3) eine Dicke zwischen 10 nm und 100 nm aufweist,
- die zweite Schicht (21, 31) jedes Doppelschichtstapels (2, 3) eine Dicke kleiner als oder gleich 10 nm aufweist.

10. Verfahren nach einem der Ansprüche 1 bis 9, wobei die erste und zweite Elektrode (E1, E2) aus einem Metallmaterial hergestellt sind, das vorzugsweise aus Al, Ag, Pt, Cr, Ni, W ausgewählt ist, und/oder aus einem leitenden transparenten Oxid hergestellt sind.

11. Verfahren nach einem der Ansprüche 1 bis 10, wobei:
- das Substrat (1), das bei Schritt a) vorgesehen wird, im sichtbaren Bereich transparent ist,
- die erste strukturierte Elektrode (E1), die bei Schritt a) vorgesehen wird, im sichtbaren Bereich halbtransparent ist,
- die zweite Elektrode (E2), die bei Schritt f) gebildet wird, im sichtbaren Bereich reflektierend ist.

12. Verfahren nach einem der Ansprüche 1 bis 10, wobei:
- das Substrat (1), das bei Schritt a) vorgesehen wird, aus einem Halbleitermaterial hergestellt ist, vorzugsweise Silizium, oder aus Glas hergestellt ist,
- die erste strukturierte Elektrode (E1), die bei Schritt a) vorgesehen wird, im sichtbaren Bereich reflektierend ist,
- die zweite Elektrode (E2), die bei Schritt f) gebildet wird, im sichtbaren Bereich halbtransparent ist.

## Claims

1. Process for manufacturing a pixel of an organic-light-emitting-diode micro-display, comprising the following successive steps:
a) providing a substrate (1) comprising a structured first electrode (E1);
b) forming in succession first and second bilayer stacks (2, 3) on the structured first electrode (E1), each bilayer stack (2, 3) comprising in succession first and second layers (20, 21; 30, 31) respectively made of first and second materials that are transparent conductive oxides able to be selectively etched;
c) etching the second bilayer stack (3) in a zone intended to accommodate a blue subpixel (PB) and in a zone intended to accommodate a green subpixel (PV), the second bilayer stack (3) being left intact under a zone intended to accommodate a red subpixel (PR);
d) etching the first bilayer stack (2) in the zone intended to accommodate the blue subpixel (PB), the first bilayer stack (2) being left intact under the zone intended to accommodate the green subpixel (PV);
e) forming a stack (5) of organic light-emitting layers, said stack being configured to emit white light and extending through the zones intended to accommodate the red, green and blue subpixels (PR, PV, PB);
f) forming a second electrode (E2) on the stack (5) of organic light-emitting layers so as to obtain an optical resonator with the first electrode (E1);
step b) being executed so that:
- the first bilayer stack (2) has a thickness chosen so that the optical resonator permits the transmission of green light,
- the first and second bilayer stacks (2, 3) have a total thickness chosen so that the optical resonator permits the transmission of red light.

2. Process according to Claim 1, wherein step a) comprises a step consisting in coating the structured first electrode (E1) with an intermediate layer (10) made of the second material, the intermediate layer (10) having a thickness chosen so that the optical resonator permits the transmission of blue light;
step b) being executed so that:
- the first bilayer stack (2) and the intermediate layer (10) have a total thickness chosen so that the optical resonator permits the transmission of green light,
- the first and second bilayer stacks (2, 3) and the intermediate layer (10) have a total thickness chosen so that the optical resonator permits the transmission of red light.

3. Process according to Claim 1 or 2, wherein the first material is a zinc oxide ZnO, preferably doped with aluminium, and the second material is tin oxide SnO₂.

4. Process according to Claim 3, wherein step c) comprises the following successive steps:
c₁) etching the tin oxide SnO₂ of the second bilayer stack (3) with a dry or wet etch,
c₂) etching the zinc oxide ZnO of the second bilayer stack (3) with a wet etch.

5. Process according to Claim 3 or 4, wherein step d) comprises the following successive steps:
d₁) etching the tin oxide SnO₂ of the first bilayer stack (2) with a dry or wet etch,
d₂) etching the zinc oxide ZnO of the first bilayer stack (2) with a wet etch.

6. Process according to one of Claims 1 to 5, wherein step c) comprises a step c₀) consisting in masking the zone intended to accommodate the red subpixel (PR) with a photoresist (6).

7. Process according to one of Claims 1 to 6, wherein step d) comprises a step d₀) consisting in masking the zone intended to accommodate the green subpixel (PV) with a photoresist (6).

8. Process according to one of Claims 1 to 7, wherein step e) is preceded by a step e₀) consisting in etching the first and second bilayer stacks (2, 3) in the zones intended to lie between the red, green and blue subpixels (PR, PV, PB).

9. Process according to one of Claims 1 to 8, wherein step b) is executed so that:
- the first layer (20, 30) of each bilayer stack (2, 3) has a thickness comprised between 10 nm and 100 nm,
- the second layer (21, 31) of each bilayer stack (2, 3) has a thickness smaller than or equal to 10 nm.

10. Process according to one of Claims 1 to 9, wherein the first and second electrodes (E1, E2) are made of a metal, preferably selected from Al, Ag, Pt, Cr, Ni and W, and/or made of a transparent conductive oxide.

11. Process according to one of Claims 1 to 10, wherein:
- the substrate (1) provided in step a) is transparent in the visible domain,
- the structured first electrode (E1) provided in step a) is semi-transparent in the visible domain,
- the second electrode (E2) formed in step f) is reflective in the visible domain.

12. Process according to one of Claims 1 to 10, wherein:
- the substrate (1) provided in step a) is made of a semiconductor, preferably silicon, or made of glass,
- the structured first electrode (E1) provided in step a) is reflective in the visible domain,
- the second electrode (E2) formed in step f) is semi-transparent in the visible domain.
